# EUROPÄISCHE PATENTANMELDUNG

(11) **EP 2 955 984 A1**
(43) Veröffentlichungstag der Anmeldung: **16.12.2015**
(21) Anmeldenummer: 15465503.9
(22) Anmeldetag: 13.02.2015
(51) Int. Cl.: H05K 7/14, H05K 5/00

(54) **GEHÄUSE FÜR ELEKTRONISCHE BAUGRUPPE SOWIE ENTSPRECHENDE LEITERPLATTE**

(71) Anmelder: Continental Automotive GmbH, 30165 Hannover (DE)
(72) Erfinder: Giuchici, Marius, 300255 Timisoara (RO); Glaser, Telmo, 93053 Regensburg (DE); Waltz, Markus, 93055 Regensburg (DE)
(74) Vertreter: Büchner, Jörg

(57) **Zusammenfassung**

Es wird ein Gehäuse (1) zur Aufnahme einer elektronischen Baugruppe mit einer Leiterplatte (2) vorgestellt, wobei das Gehäuse einen Gehäuseboden (11), Auflagepunkte (12) für die Leiterplatte (2) parallel zu diesem Gehäuseboden (11) sowie zumindest eine die Leiterplatte (2) seitlich umschließende Gehäusewand (13) aufweist.

Dabei ist zwischen Gehäusewand (13) und Leiterplatte (2) ein Spalt (14) und in diesem Spalt (14) zumindest ein Federelement (3) vorgesehen, wobei beim Einbringen der Leiterplatte (2) das Federelement (3) innerhalb des Spalts (14) zur Gehäusewand (13) hin nach außen drückbar und so die Leiterplatte (2) im Gehäuse einspannbar ist. Vorzugsweise ist das Federelement 3 sowohl über einen Befestigungspunkt (31) am Gehäuseboden (11) als auch über einen Steg (34) mit der Gehäusewand (13) bzw. einer in den Ecken des Gehäuses vorgesehenen Ausformung (16) federelastisch abgestützt.

## Beschreibung

Die Erfindung betrifft ein Gehäuse gemäß dem Oberbegriff von Anspruch 1 sowie eine entsprechende Leiterplatte.

Elektronische Baugruppen werden immer kleiner, damit aber auch empfindlicher und in einem Gehäuse angeordnet, um die elektronische Baugruppe vor Umwelteinflüssen zu schützen. Sind Sensoren, insbesondere Lage- oder Bewegungssensoren auf den elektronischen Baugruppen, ist zudem eine exakte und über die Lebensdauer der Baugruppe hinweg stabile Positionierung erforderlich. Eine Verschraubung der elektronischen Baugruppe im Gehäuse ist jedoch sehr aufwendig und wird zunehmend durch Einrast-, Einpress- oder Klemmlösungen ersetzt.

Gehäuse zur Aufnahme einer elektronischen Baugruppe mit einer Leiterplatte weisen üblicherweise einen Gehäuseboden, Auflagepunkte für die Leiterplatte parallel zu diesem Gehäuseboden sowie eine die Leiterplatte seitlich umschließende Gehäusewand auf, wobei die Gehäusewand umlaufend oder beispielsweise durch einen Steckerbereich unterbrochen sein kann.

Die Aufgabe der vorliegenden Erfindung ist es, ein zweiteiliges Gehäuse zur Aufnahme einer elektronischen Baugruppe vorzustellen, welches möglichst kleine elektronische Baugruppen ermöglicht, eine sichere Befestigung der Baugruppe im Gehäuse ermöglicht und trotzdem kostengünstig herstellbar ist.

Diese Aufgabe wird durch die Merkmale der unabhängigen Ansprüche gelöst. Vorteilhafte Weiterbildungen der Erfindung ergeben sich aus den Unteransprüchen, wobei auch Kombinationen und Weiterbildungen einzelner Merkmale miteinander denkbar sind.

Ein wesentlicher Gedanke der Erfindung besteht darin, dass im Gehäuse zwischen Gehäusewand und Leiterplatte ein Spalt vorgesehen und in diesem Spalt zumindest ein Federelement vorgesehen ist, welche beim Einbringen der Leiterplatte innerhalb des Spalts zur Gehäusewand hin nach außen drückbar und so die Leiterplatte im Gehäuse einspannbar ist.

Vorzugsweise ist das Federelement am Gehäuseboden befestigt und erzeugt das Federelement beim Einbringen der Leiterplatte eine Biegespannung über die Länge des Federelements aufgrund dieser Befestigung am Gehäuseboden. Die Leiterplatte wird durch das Federelement also in Richtung der Ebene der Leiterplatte gegen einen Gegenpunkt geklemmt.

In einer besonders bevorzugten Ausgestaltung ist das Federelement zur Gehäusewand hin zumindest abschnittsweise über einen Steg mit der Gehäusewand verbunden, wobei der Steg federelastisch ausgebildet ist. Dieser Steg kann dabei je nach Auslegung anstelle der Befestigung am Gehäuseboden oder ergänzend zu dieser die Biegung und damit Kraft zum einspannen der Leiterplatte aufbringen.

Vorzugsweise weist das Federelement auf der zum Gehäuseboden entgegengesetzten Seite eine Spitze auf, welche als Positionierungsspitze zunächst einen Abstand zur gegenüberliegenden Wand und/oder Spitze größer als der entsprechende Abstand der Leiterplatte aufweist und sich der Abstand mit zunehmender Annäherung zum Gehäuseboden bis zur Erzeugung der definierten Verspannung verengt.

In einer bevorzugten Ausgestaltung ist zudem vorgesehen, dass das Federelement an der zur Leiterplatte weisenden Seite eine abgerundete Berührungsfläche aufweist. Durch diese Abrundung können die Kräfte zwischen Federelement und Leiterplatte möglichst großflächig aufgenommen und eine leichte Verdrehbewegung ermöglicht werden, wobei vorzugsweise auch die Leiterplatte entsprechend geformt ist, also der Rand der Leiterplatte eine entsprechend nach innen abgerundete Ausformung zum Kontakt mit dem Federelement aufweist.

Grundsätzlich wäre in einer äußerst einfachen Ausgestaltung ein Gehäuse mit nur einem Federelement beispielsweise in einer der Ecken des Gehäuses und einem festen gegen Anschlagpunkt in der gegen Ecke des Gehäuses denkbar, wobei ein solches Federelement dann eine Abstützung in beide Richtungen der Leiterplattenebene erzeugt.

In einer besonders bevorzugten Ausgestaltung ist jedoch in jeder der vier Ecken des Gehäusebodens jeweils ein Federelement vorgesehen und bilden diese 4 Federelemente zusammen die Einsparung der Leiterplatte, wobei auch hier vorzugsweise jedes der Federelemente in beide Achsen der Leiterplattenebene wirkt, also quasi in Richtung der Mitte bzw. des Schwerpunkts der Leiterplatte drückt.

Vorzugsweise ist das Gehäuse das Federelement einstückig aus dem Material des Gehäuseteils geformt, also beispielsweise ein Kunststoffspritzteil.

Die Erfindung wird nachfolgend anhand von Ausführungsbeispielen unter Bezugnahme auf die Figuren näher erläutert. Es zeigen:
- Figur 1: ein erstes Ausführungsbeispiel eines Gehäuseteil des mit Federelementen in den Ecken
- Figur 2: Längsschnitt durch das Gehäuse in der Leiterplattenebene
- Figur 2 A: Detailansicht zu Figur 2
- Figur 3: Skizze der Lage der Querschnitte der Figuren 4 und 5
- Figur 4: Querschnitt am Rand der Baugruppe einschließlich durch die Federelemente
- Figur 5: Querschnitt durch die Mitte der Baugruppe

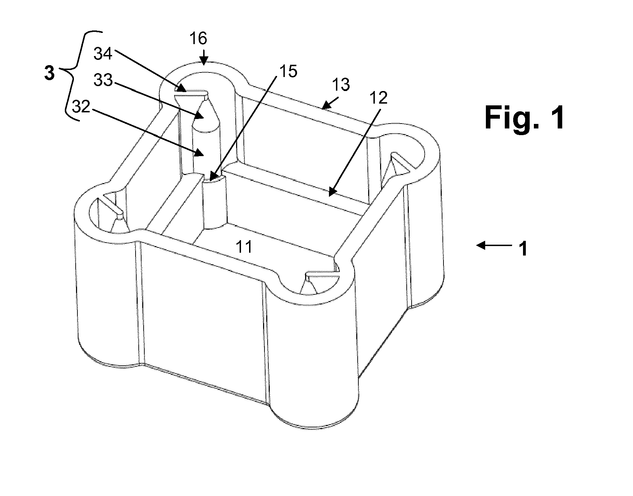

Figur 1 zeigt eine besonders bevorzugte Ausgestaltung, bei welcher in den 4 Ecken des Gehäuses 1 jeweils ein Federelement 3 angeordnet ist. Das Gehäuse (1) dient zur Aufnahme einer elektronischen Baugruppe mit einer Leiterplatte (2), wobei das Gehäuse einen Gehäuseboden (11), Auflagepunkte (12) für die Leiterplatte (2) parallel zu diesem Gehäuseboden (11) sowie zumindest eine die Leiterplatte (2) seitlich umschließende Gehäusewand (13) aufweist. In diesem Ausführungsbeispiel ist die Gehäusewand 13 komplett umlaufend, könnte jedoch durchaus auch in anderen Ausführungsbeispielen unterbrochen sein, beispielsweise durch einen Steckerbereich oder Durchbrüche für Sensoren oder Aktoren.

Zwischen zumindest einer Seite der Gehäusewand (13) und der Leiterplatte (2) ist ein Spalt (14) vorgesehen und in diesem Spalt (14) zumindest ein Federelement (3) vorgesehen, wobei beim Einbringen der Leiterplatte (2) das Federelement (3) innerhalb des Spalts (14) zur Gehäusewand (13) hin nach außen drückbar und so die Leiterplatte (2) im Gehäuse einspannbar ist.

Das Gehäuse bzw. der Gehäuseboden (11) weist hier in diesem Ausführungsbeispiel eine rechteckige Grundform mit vier Ecken und in jeder dieser vier Ecken jeweils ein Federelement (3) auf. Es sei aber nochmals ausdrücklich darauf hingewiesen, dass sich es dabei ausschließlich um eine besonders bevorzugte Ausgestaltung handelt und grundsätzlich auch ein Gehäuse denkbar wäre, bei welchem nur ein oder zwei Federelemente 3 vorgesehen sind und an der bzw. den gegenüberliegende(n) Ecke(n) in der Gehäusewand ein fester Aufnehmer für die Leiterplatte 2 vorgesehen sein könnte.

In diesem in Figur 1 dargestellten besonders bevorzugten Ausführungsbeispiel ist jedoch in jeder der 4 Ecken jeweils ein Federelement (3) und zudem die Gehäusewand (13) im Bereich der Ecke(n) mit einer nach außen gewölbten Ausformung (16) versehen, welche so bemessen ist, dass das Federelement 3 einen hinreichenden Spalt 14 in dieser Ausformung 16 vorfindet, um sich in der Leiterplattenebene entsprechend von der Mitte der Leiterplatte weg biegen zu können.

Wie in Figur 1 ebenfalls zu erkennen ist, sind die Auflagepunkte für die Leiterplatte als seitliche Stege 12 am Rand der Seitenwand 13 ausgebildet, wobei im Bereich der Federelemente 3 eine Aussparung 15 in Richtung des Gehäusebodens 11 vorgesehen ist. Diese Aussparung 15 ermöglicht, einen Materialabrieb vom Federelement 3 beim Einpressen der Leiterplatte 2 aufzunehmen und so sicherzustellen, dass die Leiterplatte 2 tatsächlich bis zu den seitlichen Stegen 12 niederdrückbar ist.

Zudem zeigt Figur 1 bereits die bevorzugten Stege 34, über welche das Federelement (3) zur Gehäusewand (13) hin zumindest abschnittsweise mit der Gehäusewand (13,16)) verbunden ist, wobei der Steg (34) federelastisch ausgebildet ist. Dieser Steg 34 übernimmt dabei zumindest einen Teil der Federkraft.

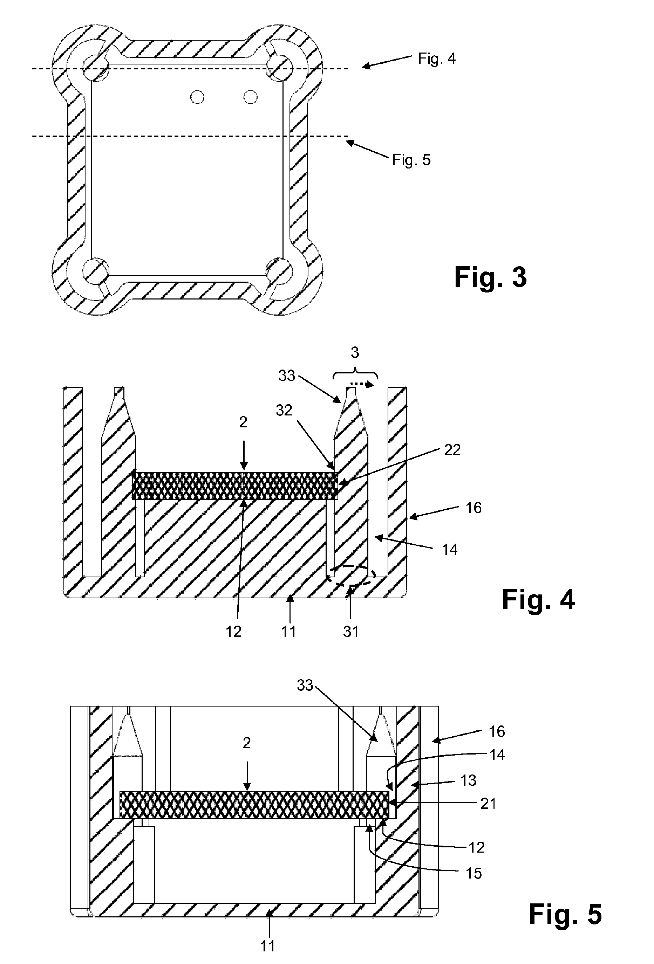

Zusätzlich ist aber, wie noch besser in Figur 4 zu erkennen ist, darüber hinaus das Federelement (3) am Gehäuseboden (11) an einem Befestigungspunkt (31) befestigt und wird beim Einbringen der Leiterplatte (2) eine Biegespannung über die Länge des Federelements (3) auch in diese Befestigung (31) am Gehäuseboden (11) erzeugt.

In dieser bevorzugten Ausgestaltung ist das Federelement (3) einstückig aus dem Material des Gehäuseteils (1), also beispielsweise einem Kunststoffspritzguss mit entsprechenden Materialeigenschaften geformt, gegebenenfalls einem 2-Komponenten-Spritzguss mit entsprechend federelastischen Materialien insbesondere für den Steg 34 und/oder den Befestigungspunkt 31.

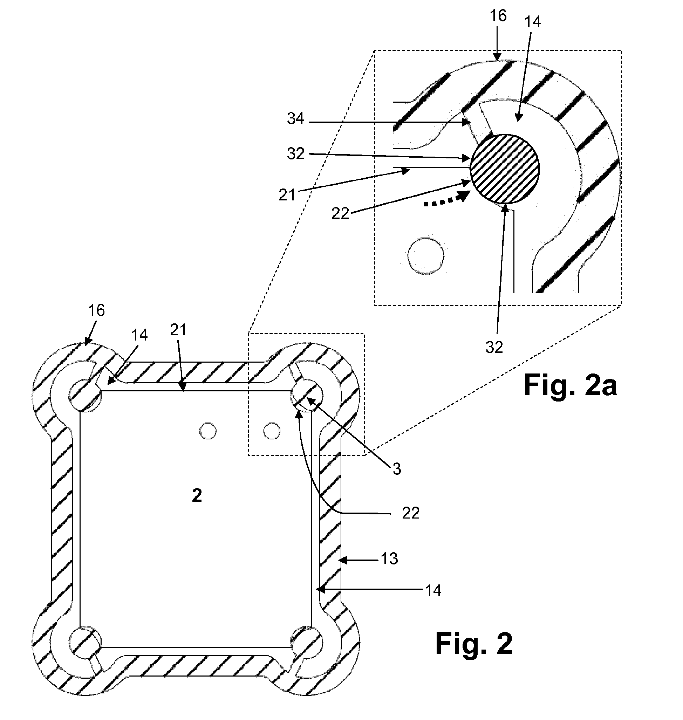

Figur 2 zeigt nun einen Schnitt durch die Baugruppe in einer Ebene knapp oberhalb der Leiterplatte nach dem Einbringen der Leiterplatte 2. Besonders gut erkennbar ist in dieser Darstellung der Spalt 14 umlaufend um die Leiterplatte zur Gehäusewand 13 bzw. den Ausformungen 16 hin. Computertechnisch bedingt ist die Position des Federelements 3 dabei gerade in der unverspannten Ausgangsposition überlappend zum entsprechenden Randbereich 22 der Leiterplatte 2 gezeigt, was natürlich nicht der Realität entspricht, andererseits aber das Maß der erforderlichen Verbiegung des Federelements 3 verdeutlicht.

Korrekt ist hingegen in der Detailansicht in Figur 2A das Federelement 3 durch den Rand 22 der Leiterplatte 2 wie durch den gestrichelten Pfeil angedeutet nach außen weiter in den Spalt 14 gedrückt.

Auch wenn in Figur 2A die Schraffur des Schnitts durch das Federelement 3 abweichend zur Schraffur des Schnitts durch die Gehäusewand 13 und Ausformung 16 sowie den Steg 34 gezeigt ist, so liegt auch dies rein an der computertechnischen Umsetzung der Skizzen und können die Elemente alle einstückig aus ein und demselben Kunststoffmaterial sein. In Realität wären dabei auch der Steg 34 ein Stück in Pfeilrichtung gebogen, konnte dies aber in der Figur 2A aus computertechnischen Gründen so nicht umgesetzt werden, für den Fachmann aber auch so ohne weiteres verständlich.

Gut zu erkennen ist in Figur 2A, dass das Federelement (3) an der zur Leiterplatte weisenden Seite eine abgerundete Berührungsfläche (32) und der Rand der Leiterplatte (2) eine entsprechend abgerundete Ausformung (22) zum Kontakt mit dem Federelement (3) aufweist. Dadurch kann bei Biegebelastung des Steges 34 eine kugellagerartige Verschiebung zwischen dem Federelement 3 und der Leiterplatte 2 oder genauer gesagt zwischen der abgerundeten Berührungsfläche 32 und der Ausformung 22 erfolgen.

Figur 3 dient ausschließlich der Veranschaulichung der Position der 2 Querschnitte, welche nachfolgend in den Figuren 4 und 5 gezeigt sind.

Dabei zeigt Figur 4 einen Querschnitt im Randbereich des Gehäuses durch die Ausformungen 16 und die Federelemente 3 hindurch. Gut zu erkennen in dieser Darstellung ist, wie die Leiterplatte 2 auf den seitlichen Stegen 12 aufliegt und im Berührungsbereich 32 gegen die Federelemente 3 drückt und die Federelemente 3 im Befestigungsbereich 31 mit der Grundfläche 11 des Gehäuses verbunden sind.

Zudem weist das Federelement (3) auf der zum Gehäuseboden (11) entgegengesetzten Seite eine Spitze (33) auf, welche als Positionierungsspitze zunächst einen Abstand zur gegenüberliegenden Wand und/oder Spitze(n) größer als der entsprechende Abstand der Leiterplatte (2) aufweist und sich der Abstand mit zunehmender Annäherung zum Gehäuseboden (11) bis zur Erzeugung der definierten Verspannung verengt. Die Leiterplatte 2 weist dabei im Schnittbereich in Figur 4 eine breite auf, welche aufgrund der Ausformungen 22 kleiner ist als die Breite der Leiterplatte 2 in Querschnitt gemäß Figur 5 als Abstand zwischen den Seitenflächen 21, welche dort ja einen Spalt 14 zur Wand 13 des Gehäuses aufweisen.

Figur 5 zeigt nun noch einen weiteren Querschnitt durch die Baugruppe an der in Figur 3 skizzierten Stelle, wobei dieser Schnitt die ja größere Breite der Leiterplatte 2 zwischen den Seitenwänden 21 und den verbleibenden Spalt 14 zur Seitenwand 13 des Gehäuses zeigt. Zudem ist in dieser Figur noch mal die Aussparung 15 zu erkennen, welche den Materialabrieb des Filterelements 3 beim Einpressen der Leiterplatte 2 in das Gehäuse aufnehmen soll.

Ein solches Gehäuse mit einer entsprechenden Leiterplatte eignet sich insbesondere für kleine Baugruppen, beispielsweise in Kraftfahrzeugen für aus einem zentralen Steuergerät ausgelagerte Sensorbaugruppen, wie beispielsweise so genannte Up-Front-Sensoren oder Drucksensoren in den Seitentüren.

## Patentansprüche

1. Gehäuse (1) zur Aufnahme einer elektronischen Baugruppe mit einer Leiterplatte (2), wobei das Gehäuse einen Gehäuseboden (11), Auflagepunkte (12) für die Leiterplatte (2) parallel zu diesem Gehäuseboden (11) sowie zumindest eine die Leiterplatte (2) seitlich umschließende Gehäusewand (13) aufweist, **dadurch gekennzeichnet, dass** zwischen Gehäusewand (13) und Leiterplatte (2) ein Spalt (14) vorgesehen ist und in diesem Spalt (14) zumindest ein Federelement (3) vorgesehen ist, wobei beim Einbringen der Leiterplatte (2) das Federelement (3) innerhalb des Spalts (14) zur Gehäusewand (13) hin nach außen drückbar und so die Leiterplatte (2) im Gehäuse einspannbar ist.

2. Gehäuse nach Anspruch 1, **dadurch gekennzeichnet, dass** das Federelement (3) am Gehäuseboden (11) an einem Befestigungspunkt (31) befestigt ist und beim Einbringen der Leiterplatte (2) eine Biegespannung über die Länge des Federelements (3) in diese Befestigung (31) am Gehäuseboden (11) erzeugt.

3. Gehäuse nach Anspruch 1 oder 2, **dadurch gekennzeichnet, dass** das Federelement (3) zur Gehäusewand (13) hin zumindest abschnittsweise über einen Steg (34) mit der Gehäusewand (13,16) verbunden ist, wobei der Steg (34) federelastisch ausgebildet ist.

4. Gehäuse nach einem der vorangehenden Ansprüche, **dadurch gekennzeichnet, dass** das Federelement (3) auf der zum Gehäuseboden (11) entgegengesetzten Seite eine Spitze (33) aufweist, welche als Positionierungsspitze zunächst einen Abstand zur gegenüberliegenden Wand und/oder Spitze(n) größer als der entsprechende Abstand der Leiterplatte (2) aufweist und sich der Abstand mit zunehmender Annäherung zum Gehäuseboden (11) bis zur Erzeugung der definierten Verspannung verengt.

5. Gehäuse nach einem der vorangehenden Ansprüche, **dadurch gekennzeichnet, dass** das Federelement (3) an der zur Leiterplatte weisenden Seite eine abgerundete Berührungsfläche (32) aufweist.

6. Gehäuse nach einem der vorangehenden Ansprüche, **dadurch gekennzeichnet, dass** der Gehäuseboden (11) vier Ecken und in jeder dieser vier Ecken jeweils ein Federelement (3) aufweist.

7. Gehäuse nach einem der vorangehenden Ansprüche, **dadurch gekennzeichnet, dass** das Federelement (3) einstückig aus dem Material des Gehäuseteils (1) geformt ist.

8. Gehäuse nach einem der vorangehenden Ansprüche, **dadurch gekennzeichnet, dass** das Gehäuseteil (1) eine rechteckige Grundform und an zumindest einer der Ecken ein Federelement (3) und die Gehäusewand (13) im Bereich der Ecke(n) eine Ausformung (16) aufweist.

9. Leiterplatte für elektronische Baugruppe zur Montage in einem Gehäuse nach einem der vorangehenden Ansprüche, **dadurch gekennzeichnet, dass** der Rand der Leiterplatte (2) eine Ausformung (22) zum Kontakt mit dem Federelement (3) aufweist.

10. Sensorbaugruppe für Kraftfahrzeuge mit einem Gehäuse (1) nach einem der Ansprüche 1-8 und einer Leiterplatte nach Anspruch 9.
